# EUROPÄISCHE PATENTANMELDUNG

(11) **EP 2 568 296 A1**
(43) Veröffentlichungstag der Anmeldung: **13.03.2013**
(21) Anmeldenummer: 11180884.6
(22) Anmeldetag: 12.09.2011
(51) Int. Cl.: G01R 1/20, H01C 10/46

(54) **Kurzschlussstromgeschützter Messwiderstand**

(71) Anmelder: Eaton Industries GmbH, 53115 Bonn (DE)
(72) Erfinder: Freyermuth, Thomas, 53505 Kalenborn (DE)
(74) Vertreter: Leadbetter, Benedict

(57) **Zusammenfassung**

Messwiderstand (1) zum Messen eines elektrischen Stromes umfassend zwei Stromanschlussvorrichtungen (21), wenigstens ein zwischen den Stromanschlussvorrichtungen (21) angeordnetes und mit ihnen leitend verbundenes Widerstandselement (3), und eine zwischen den Stromanschlussvorrichtungen (21) angeordnete und mit ihnen leitend verbundene elektronische Einheit (4) zur Erfassung und Verarbeitung eines Messsignals. dadurch gekennzeichnet, dass eine Bypassvorrichtung (5,6) zur Überbrückung des Widerstandselements (3) vorgesehen ist, wobei eine durch den Strom verursachte Kraft die Bypassvorrichtung (5,6) in eine Aktivstellung bewegt oder in der Aktivstellung hält, wenn der Strom zwischen den Stromanschlussvorrichtungen (21) über einem definierten Ansprechwert liegt, und dass die Bypassvorrichtung (5,6) wenigstens einen Bypassleiter (6) umfasst, durch den ein Anteil des Stromes zwischen den Stromanschlussvorrichtungen (21) fließt, wenn die Bypassvorrichtung (5,6) sich in der Aktivstellung befindet.

## Beschreibung

Die Erfindung betrifft einen Messwiderstand zum Messen eines elektrischen Stromes. Der Messwiderstand umfasst zwei Stromanschlussvorrichtungen, wenigstens ein zwischen den Stromanschlussvorrichtungen angeordnetes und mit ihnen leitend verbundene Widerstandselement und eine elektronische Einheit zur Erfassung und Verarbeitung eines Messsignals, wobei die elektronische Einheit zwischen den Stromanschlussvorrichtungen angeordnet ist und mit ihnen leitend verbunden ist,

Die DE 296 10 403 U1 beschreibt den Aufbau eines Standard-Shunt-Messwiderstands in Form einer NH-Sicherung zum Einsatz in NH-Sicherungshaltern, der Stromanschlussvorrichtungen. zwei Anschlussplatten sowie Widerstandselemente umfasst. die sich zueinander im Wesentlichen parallel zwischen den Anschlussplatten erstrecken.

In der Regel umfasst ein Messwiderstand eine elektronische Einheit, die das Messsignal im Messwiderstand verstärkt. digitalisiert und zur Weiterverarbeitung überträgt. Zumeist ist die elektronische Einheit außerhalb des Shunts, jedoch in der Nãhe des stromführenden Widerstandselements angeordnet. Ein Nachteil dieser Anordnung liegt darin, dass so die stromerzeugten Magnetfelder die Messungen störend beeinflussen können.

In der DE 296 05 606 Ul wird ein Messwiderstand beschrieben, der zwei Stromanschlussvorrichtungen in Form von Anschlussplatten, ein zwischen ihnen angeordnetes Widerstandselement sowie eine elektronische Einheit umfasst. Die elektronische Einheit ist mit den Stromanschlussvorrichtungen leitend verbunden und befindet sich im inneren eines elektrischen Hoblleiters. Die elektronische Einheit ist durch ihre Anordnung vor dein Einfluss eines Magnetfeldes geschützt, weil der Innenraum des elektrischen Hohlleiters frei von Magnetfeld ist. Das Widerstandselemem und der Hohlleiter sind allerdings räumlich hintereinander angeordnet, so dass ein zusätzlicher Platzbedarf für die Unterbringung der elektronischen Einheit entsteht.

Aus der DE 195 10 662 Al ist ein Messwiderstand bekannt, der zwei Stromanschlussvorrichtungen, zwei Widerstandselemente und eine elektronische Einheit umfasst. Die elektronische Einheit ist in einem Hohlraum untergebracht, der durch die Stromanschlussvorrichtungen und die Widerstandselemente gebildet wird. Dieser Aufbau soll einen mechanischen Schutz der elektronischen Einheit gewährleisten und gleichzeitig den Einwirkungen hochfrequenter Störungen auf die elektronische Einheit entgegenstehen. Allerdings ist hier der Schutz vor solchen Störungen nicht optimal, weil der geometrische Aufbau des Messwiderstandes von einer zylindrischen Form wesentlich abweicht. Zudem wird das Problem der Hitzeentwicklung bzw. einer entsprechenden Kühlung im Messwiderstand im Fall von Überlastströmen nicht thematisiert. Letztlich sind die Sensoranschlüsse der elektronischen Einheit an der Innenseite des Messwiderstandes unterschiedlich lang geführt, wodurch unterschiedliche Kapazitäten der Sensorleitungen entstehen, die den Messwert beeinflussen.

Die EP 0 605 800 B1 offenbart ein Verfahren zur Herstellung elektrischer Messwiderstände, insbesondere niederohmiger Messwiderstände. Mit diesem Verfahren können Widerstände hergestellt werden, deren Widerstandswert im µΩ-Bereich liegt.

Die Verwendung von Messwiderständen, die Widerstandswerte im Bereich von µΩ aufweisen, bringt den Vorteil besonders niedriger Verlustleistungen mit sich. Dennoch ist der Einsatz solcher Messwiderstände im Bereich der Leistungsschalter unüblich. Der Grund dafür ist ihre Anfälligkeit für thermische Schädigung aufgrund einer Überlast im Fall hoher Ströme (z.B. Kurzschlussströme). Außerdem ergibt ein Widerstandswert im µΩ-Bereich sehr kleine Messspannungen für die elektronische Einheit, deren elektrischer Aufbau und gegebenenfalls deren Verstärker darauf abgestimmt sein müssen. Dies bedeutet einen vergleichsweise hohen Preis für die einzelnen Komponenten.

Aufgabe der vorliegenden Erfindung ist daher die Bereitstellung eines magnetfeldgeschützten Messwiderstandes mit erhöhter Überlastfähigkeit.

Die Aufgabe wird erfindungsgemäß durch die Merkmale des Anspruchs 1 gelöst. Demnach zeichnet sich der erfindungsgemäße Messwiderstand dadurch aus, dass er eine Bypassvorrichtung zur Überbrückung des Widerstandselements vorsieht- wobei eine durch den Strom verursachte Kraft die Bypassvorrichtung in eine Aktivstellung bewegt oder in der Aktivstellung hält. wenn der Strom zwischen den Stromanschlussvorrichtungen über einem definierten Ansprechwert liegt. Zudem umfasst die Bypassvorrichtung wenigstens einen Bypassleiter, durch den ein Anteil des Stromes zwischen den Stromanschlussvorrichtungen fließt, wenn die Bypassvorrichtung sich in der Aktivstellung befindet.

Bevorzugt liegt die elektronische Einheit auf einer die beiden Stromanschlussvorrichtungen verbindenden Verbindungsachse. Dadurch wird die Länge der Leitungen von den Stromanschlußvorrichtungen zu der elektronischen Einheit minimal gehalten. Auf zusätzlichen Platz für die Unterbringung der elektronischen Einheit kann zudem verzichtet werden.

Der Messwiderstand kann zwei oder mehr Widerstandselemente umfassen. Eine bevorzugte Ausführungsform der Erfindung sieht vor, dass der Messwiderstand mindestens drei Widerstandselemente umfasst. Die Widerstandselemente sind voneinander beabstandet, zumindest teilweise als im Wesentlichen gerade Leiterstücke ausgebildet und erstrecken sich im Wesentlichen parallel zueinander. Bevorzugt sind die Widerstandselemente von der Verbindungsachse beabstandet und begrenzen zusammen mit den Stromanschlussvorrichtungen einen Raumabschnitt, innerhalb dessen die elektronische Einheit angeordnet ist. In einer besonders bevorzugten Ausführungsform der Erfindung sind die Widerstandselemente mit gleichem Abstand zwischen zwei benachbarten Widerstandselementen auf einer Zylinderfläche um die Verbindungsachse angeordnet, im Bereich derer sich die elektronische Einheit befindet. Somit liegt die letztere im Zentrum des durch den Strom erzeugten Gesamt-Magnetfeldes, Dies hat den Vorteil, dass die elektronische Einheit frei vom Magnetfeld der Widerstandselemente und darüber hinaus geschützt gegenüber Fremdfeldern ist. Ein zusätzlicher Vorteil dieser Anordnung ist die Minimierung eventueller Stromverdrangungseffekte auf die Strommessung.

Wie oben erwähnt, wird das von der elektronischen Einheit erfasste Messsignal durch die elektronische Einheit verarbeitet. Die Verarbeitung kann dabei eine Verstärkung des Signals, seine Digitalisierung und/oder seine Umwandlung in ein optisches oder Funksignal umfassen. Anschließend wird das Messsignal von der elektronischen Einheit zur Weiterverarbeitung nach außen geleitet. Das Messsignal kann zum Beispiel über eine Koaxialleitung aus dem Messwiderstand herausgeführt werden. Alternativ kann das Messsignal über einen Lichtwellenleiter aus dem Messwiderstand herausgeführt werden. Auch kann das Messsignal per Funk oder über eine Lichtsender LED (es kann z.B. eine Infrarotdiode sein) übertragen werden.

In einer bevorzugten Ausführungsform der Erfindung umfasst die Bypassvorrichtung ein bewegbares ferromagnetisches Element. Das ferromagnetische Element ist derart gelagert, dass es durch elektromagnetische Wechselwirkung zwischen ihm und dem stromdurchflossenen Widerstandselement Lageänderung erfahren kann. Es wird dabei der Effekt ausgenützt, dass das Magnetfeld des stromdurchflossenen Widerstandselements durch Magnetisierung des ferromagnetischen Elements eine Anziehungskraft auf das ferromagnetische Element erwirkt.

Vorzugsweise besteht das ferromagnetische Element aus Eisen, es kann aber auch aus einen anderen Material mit ferromagnetischen Eigenschaften, wie z.B. Nickel, oder aus einer ferromagnetischen Legierung hergestellt sein.

Des Weiteren ist das ferromagnetische Element bevorzugt als flächiges Segment ausgebildet, das sich seiner Länge nach von der einen bis zu der anderen Stromanschlussvorrichtung erstreckt und das zwischen den Stromanschlussvorrichtungen angeordnete Widerstandselement zumindest teilweise umschirmt. Besonders bevorzugt weist das ferromagnetische Element sich in Hauptstromrichtung erstreckende Schlitze auf Die Schlitze sorgen für eine verbessert Luftzirkulation im Messwiderstand, so dass damit eine verbesserte Kühlung der Widerstandselemente und der elektronischen Einheit erreicht wird. Die Schlitze verlaufen vorzugsweise im Wesentlichen parallel zueinander. Auf diese Weise werden eventuelle Wirbelströme im ferromagnetischen Element minimiert.

Für die Schutzfunktion der Bypassvorrichtung ist es wesentlich, dass durch die Bypassleiter der Bypassvorrichtung ein Anteil des Stromes zwischen den Stromanschlussvorrichtungen fließt, wenn sich die Bypassvorrichtung in der Aktivstellung befindet. Für die Materialzusammensetzung der Bypassleiter eignen sich deshalb jene Stoffe besonders gut, die einen möglichst geringen Widerstandswert aufweisen oder zumindest einen Widerstandswert aufweisen, der nicht wesentlich größer als der Widerstandswert der Widerstandselemente ist. In einer bevorzugten Ausführungsform der Erfindung sind die Stromanschlussvorrichtungen und der Bypassleiter zumindest teilweise aus Kupfer ausgebildet Die Oberfläche der Bypassleiter kann auch zum Beispiel versilbert werden. Lichtbogenprobleme, wie sie oft bei Schaltern vorkommen, können hier wegen der kleinen Schaltspannungen nicht auftreten.

Zur bewegbaren Lagerung des ferromagnetischen Elements ist vorzugsweise mindestens ein Federteil vorgesehen. Als Federteil wird dabei jedes zur bewegbaren Lagerung, des ferromagnetischen Elements geeignete Element verstanden, das über elastische Rückstelleigenschaften verfügt, wie zum Beispiel Druckfedern. Tellerfedern, Biegefedern und dergleichen. Das Federteil stellt eine elastische Verbindung zwischen dem ferromagnetisehen Element und einem anderen Teil des Messwiderstands, wie zum Beispiel einem weiteren ferromagnetischen Element.

Gemäß einer bevorzugten Ausführungsform umfasst der Messwiderstand eine Isolierung. Die Isolierung kann benachbart zu einer der Stromanschlussvorrichtungen angeordnet und mit ihnen fest verbunden sein. Das ferromagnetische Element ist vorzugsweise an der Isolierung bewegbar gelagert. Die Lagerung erfolgt besonders vorteilhaft mittels des Federteils,

In einer weiteren bevorzugten Ausführungsform umfasst der Messwiderstand zwei Isolierungen, die jeweils benachbart zu den Stromanschlussvorrichtungen angeordnet sind. Das ferromagnetische Element kann an einer der Isolierungen, aber auch an beiden Isolierungen bewegbar gelagert sein, vorzugsweise jeweils mittels des Federteils.

Die Isolierungen können in Form im Wesentlichen kreisförmiger Scheiben ausgebildet sein. Zudem kann jede der Stromanschlussvorrichtungen eine im Wesentlichen kreisförmige Ansechlussplatte umfassen. Jedes Paar, bestehend aus einer Isolierung und einer Anschlussplatte ist vorzugsweise derart ausgebildet, dass die Projektion der Isolierung und der zugehörigen Anschlussplatte in die Kreisebene eine Abbildung zweier konzentrischer Kreise ergibt. wobei der Radius des der Isolierung entsprechenden Kreises bevorzugt größer ist als der Radius des der Anschlussplatte entsprechenden Kreises.

Eine weitere Ausführungsform der Erfindung sieht mindestens zwei ferromagnetische Elemente vor, die miteinander bewegbar verbunden sind. Zur Verbindung der beiden ferromagnetischen Elemente ist mindestens ein geeignetes Federteil vorgesehen.

Gemäß einem weiteren Ausfürungsbeispiel der Erfindung umfassen die zwei Stromanschlussvorrichtungen des Messwiderstandes jeweils eine im Wesentlichen rechteckige Anschlussplatte. Es kommen auch andere Grundformen in Frage, wie z.B. dreieckig, fünfsechs- oder siebeneckig in Frage.

Nach einer bevorzugten Ausführung der Erfindung wird eine Überbrückung des mindestens einen Widerstandselements dadurch erreicht, dass der Bypassleiter in der Aktivstellung der Bypassvorrichtung eine Strom führende Verbindung zwischen den Stromanschlussvorrichtungen herstellt. Vorzugsweise ist dabei der Bypassleiler derart angeordnet, dass durch eine Verformung des Federteils entgegen seiner Rückstellkraft eine Verlagerung des Bypassleiters erreicht werden kann, so dass ein elektrischer Kontakt zwischen den Anschlussplatten und dem Bypassleiter hergestellt werden kann. Demnach sieht eine bevorzugte Ausführung der Erfindung vor, dass der durch das Widerstandselement fließende Strom eine magnetische Kraft auf die Bypassvorrichtung gegen die Rückstellkraft des Federteils erwirkt. Durch diese magnetische Kraft wird das Federteil belastet und die Bypassvorrichtung in ihre Aktivstellung bewegt. Dabei wirkt die Kraft zunächst insbesondere auf das ferromagnetische Element, das durch seine Bewegung seinerseits den Bypassleiter verlagert. Der Bypassleiter ist, wenn Strom über ihn fließt ebenso von einem Magnetfeld umgeben. Dieses Magnetfeld verstärkt seinerseits das schon wirkende Feld und erhöht die Kraftwirkung auf die Kontaktstellen des Bypassleiter. Die Kontaktübergangswiderstände werden dadurch kleiner. Nun kann der Bypassleiter mehr Strom übernehmen und den Shunt weiter entlasten. Die Bypassvorrichtung wird in der Aktivstellung gehalten wenn der Strom zwischen den Stromanschlussvorrichtungen über einem definierten Ansprechwert liegt. In der Aktivstellung der Bypassvorrichtung ist eine elektrische Verbindung zwischen dem Bypassleiter und den Anschlussplatten hergestellt. so dass der Bypassleiter am Stromfluss zwischen den Stromanschlussvorrichtungen teilnimmt,

Eine weitere Ausführungsform der Erfindung sieht vor, dass der Bypassleiter zweiteilig ausgebildet ist. Er umfasst einen ersten und einen zweiten Bypassleiterteil. Beide Teile des Bypassleiters sind vorzugsweise leitend mit jeweils einer Anschlussplatte verbunden. Solange sich die Bypassvorrichtung nicht in der Aktivstellung befindet führt der Bypassleiter keinen Strom aufgrund einer isolierenden Unterbrechung zwischen zwei Enden der beiden Bypassleiterteile. Vorzugsweise ist der zweiteilige Bypassleiter derart angeordnet, dass durch eine Belastung des Federteils elektrisch leitende Verbindung zwischen den beiden Bypassleiterteilen hergestellt werden kann. In einer bevorzugten Ausführung drückt das ferromagnetische Element bei einer magnetischen Krafteinwirkung gegen die Rückstellkraft des Federteils auf diejenigen Enden der Bypassleiterteile, die mit keiner der Anschlussplatten in Verbindung stehen, so dass diese sich in Richtung zueinander bewegen. und dass schließlich durch Kontakt zwischen ihnen eine leitende Verbindung zwischen den Bypassleiterteilen erreicht wird.

Die Erfindung wird ferner in Verbindung mit den beiliegenden Figuren beschrieben, wobei
- Figur 1a: eine perspektivische Darstellung eines Ausführungsbeispieles eines erfindungsgemäßen Messwiderstandes zeigt;
- Figur 1b: eine perspektivische Teilsicht des Messwiderstandes aus Figur 1a zeigt;
- Figur 2a: eine perspektivische Darstellung eines weiteren Ausführungsbeispieles des erfindungsgemäßen Messwiderstandes zeigt;
- Figur 2b: eine perspektivische Teilsicht des Messwiderstandes aus Figur 2a zeigt.

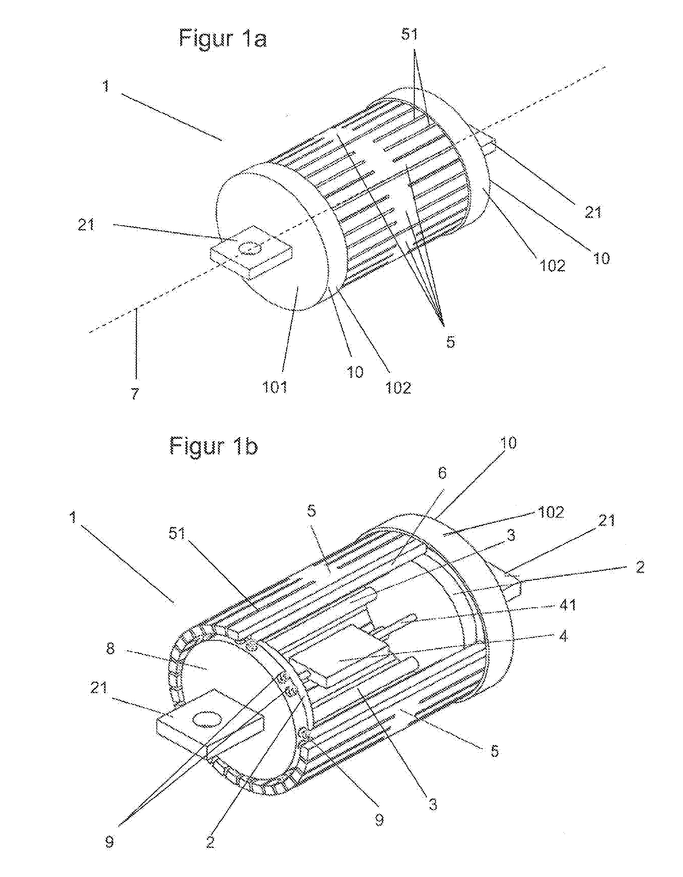

Figuren 1a und 1b zeigen ein Ausführungsbeispiel eines erfindungsgemäßen Messwiderstandes 1 in perspektivischer Ansicht. Bei Figur 1b sind Teile des Messwiderstands herausgeschnitten, um in der Figur 1a verdeckte Bauteile sichtbar zu machen.

Der Messwiderstand 1 umfasst zwei Stromanschlussvorrichtungen 21, zwei daran anschließende Anschlussplatten 2 sowie Widerstandselemente 3, wobei sich die Widerstandselemente 3 zwischen den Anschlussplatten 2 erstrecken und mit ihnen leitend verbunden sind. Im Bereich einer Verbindungsachse 7, die die beiden Stromanschlussvorrichtungen 21 miteinander verbindet, ist eine elektronische Einheit 4 angeordnet. Die elektronische Einheit 4 ist leitend über gleich lange Sensoranschlüsse 41 mit den Anschlussplatten 2 verbunden. Der Messwiderstand umfasst ferner zwei Isolierplatten 8. Die Anschlussplatten 2 und die Isolierplatten 8 sind in Form von Kreisscheiben ausgebildet, deren Mittelpunkt auf der Verbindungsachse 7 liegt. Der Radius der Isolierplatten 8 ist größer als der Radius der Anschlussplatten 2.

Der Messwiderstand 1 umfasst ferner eine Bypassvorrichtung, die mehrere ferromagnetische Elemente 5 sowie Bypassleiter 6 umfasst. Zudem umfasst der Messwiderstand 1 zwei Halteplatten 10, die benachbart zu den Stromanschlussvorrichtungen angeordnet sind. Die Halteplatten 10 weisen eine kreisförmige Grundfläche 101 und eine zylindertörmige Seitenfläche 102 auf. Die Halteplatten 10 begrenzen durch ihre zylinderförmige Seitenfläche 102 eine radiale Bewegung der ferromagnetischen Elemente 5 nach außen.

Die Widerstandselemente 3 und die elektronische Einheit 4 befinden sich innerhalb des von den Stromanschlussvorrichtungen 21, den Halteplatten 10 und den ferromagnetischen Elementen 5 begrenzten Raumabschnitts.

Die ferromagnetischen Elemente 5 sind voneinander beabstandet, so dass eine Radialbewegung der ferromagnetischen Elemente 5 in Richtung der Verbindungsachse 7 möglich ist. Ferner weisen die terromagnetischen Elemente 5 Schlitze 51 auf. Die Schlitze 51 verlaufen im Wesentlichen parallel zur Verbindungsachse 7 und zueinander. Die Schlitze 51 begrenzen zusammen mit den Seitenrändern der ferromagnetischen Elemente 5 einzelne Bereiche der ferromagnetischen Elemente 5, die bei geeigneter Kraftwirkung unabhängig voneinander bewegbar sind.

Die ferromagnetischen Elemente 5 sind mittels Federteile 9 bewegbar mit den beiden Isolierplatten 8 verbunden. Benachbart zu den ferromagnetischen Elementen 5 sind Bypassleiter 6 angeordnet. Jeder Bypassleiter 6 ist fest mit einem der ferromagnetischen Elemente 5 verbunden (z.B. vernietet). Befindet sich die Bypassvorrichtung nicht in Aktivstellung, so ist eine Radialbewegung eines jeden ferromagnetischen Elements 5 einerseits durch die beiden Halteplatten 10 und anderseits durch die Rückstellkraft der Federteile 9 festgelegt. Überschreitet der Strom durch die Widerstandselemente 3 einen vordefinierten Ansprechwert, so werden die ferromagnetischen Elemente 5 durch die elektromagnetische Kraft, die zwischen den Widerstandselementen 3 und den ferromagnetischen Elementen 5 gegen die Rückstellkraft der Federteile 9 wirkt, radial in Richtung der Verbindungsachse 7 bewegt. Gleichzeitig werden die mit den ferromagnetischen Elementen 5 fest verbundenen Bypassleiter 6 in gleiche Richtung bewegt. Die Aktivstellung der Bypassvonichtung wird erreicht, wenn zwischen den Bypassleitern 6 und den Anschlussplatten 2 elektrischer Kontakt hergestellt ist. Nehmen in Folge der elektrischen Kontaktierung die Bypassleiter 6 am Stromfluss teil. so wirkt zwischen ihnen und den Widerstandselementen 3 eine elektromagnetische Anziehungskraft, die durch die Wechselwirkung der zugehörigen Magnetfelder entsteht. Dadurch werden die Bypassleiter 6 zusätzlich gegen die Anschlussplatten 2 gedrückt. Dies hat den Vorteil, dass Kontaktwiderstand an den Kontaktstellen vermindert wird und eventueller schwach leitender Belag an der Oberfläche der Bypassleiter 6 bzw. der Anschlussplatten 2 überwunden werden kann. Ein kleinerer Kontaktwiderstand hat wiederum einen höheren Stromfluss im Bypassleiter 6 zur Folge, wodurch dann die elektromagnetische Anziehungskraft weiter steigt.

Sinkt der Strom durch die Widerstandselemente 3 und die Bypassleiter 6 unter den Ansprechwert, so überwiegt die Rückstellkraft der Federteile 9 die elektromagnetische Anziehungskraft und die Bypassvorrichtung kehrt in ihre Ausgangsstellung zurück, in der kein elektrischer Kontakt zwischen den Bypassleitern 6 und den Anschlussplatten 2 besteht.

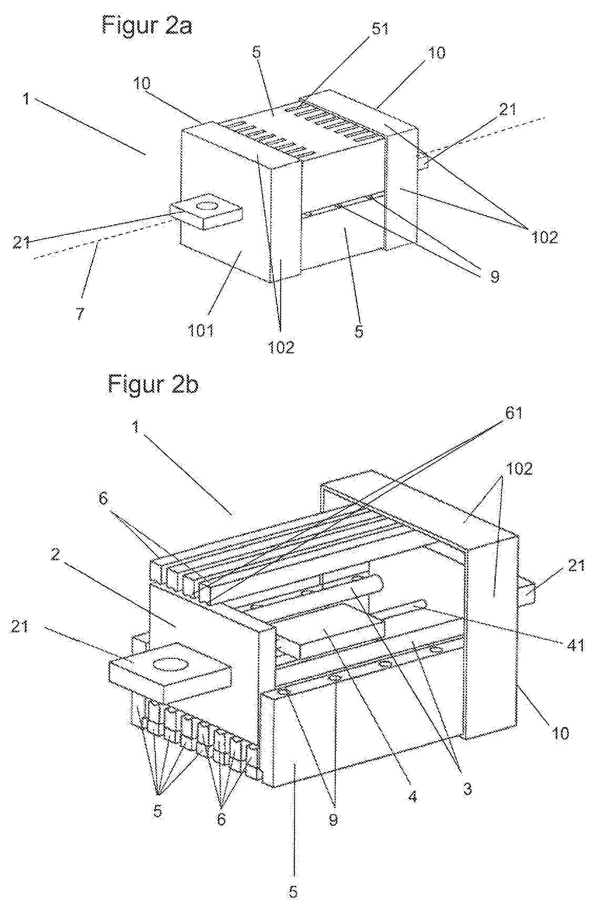

Figuren 2a und 2b zeigen ein weiteres Ausführungsbeispiel des erfindungsgemäßen Messwiderstandes 1 in perspektivischer Ansicht. Bei Figur 2b sind Teile des Messwiderstands herausgeschnitten, um in der Figur 2a verdeckte Bauteile sichtbar zu machen. Bauteile, die gleichen oder ähnlichen Bauteilen in Figuren 1a, 1b entsprechen, wurden mit gleichen Bezugszeichen gekennzeichnet.

Der Messwiderstand 1 umfasst zwei Stromanschlussvorrichtungen 21, zwei daran anschließende Anschlussplatten 2 sowie die Widerstandselemente 3, wobei sich die Widerstandselemente 3 zwischen den Anschlussplatten 2 erstrecken und mit ihnen leitend verbunden sind. Im Bereiche der Verbindungsachse 7, die die beiden Stromanschlussvorrichtungen 21 miteinander verbindet, ist die elektronische Einheit 4 angeordnet, Die elektronische Einheit 4 ist leitend über die gleich langen Sensoranschlüsse 41 mit den Anschlussplatten 2 verbunden. Die Anschlussplatten 2 sind in Form quadratischer Scheiben, ausgebildet, deren Mittelpunkt auf der Verbindungsachse 7 liegt.

Der Messwiderstand 1 umfasst ferner die Bypassvorrichtung, die zwei ferromagnetische Elemente 5 sowie Bypassleiter 6 umfasst. Zudem umfasst der Messwiderstand 1 zwei Halteplatten 10, die benachbart zu den Stromanschlussvorrichtungen angeordnet sind. Die Halteplatten 10 weisen eine rechteckige Grundfläche 101 und vier Seitenflächen 102 auf. Die Halteplatten 10 begrenzen durch ihre Seitenflächen 102 eine Bewegung der ferromagnetischen Elemente 5 nach außen.

Die Widerstandselemente 3 und die elektronische Einheit 4 befinden sich innerhalb des von den Stromanschlussvorrichtungen 21, den Halteplatten 10 und den ferromagnetischen Elementen 5 begrenzten Raumabschnitts.

Die ferromagnetischen Elemente 5 sind voneinander beabstandet, so dass eine Bewegung der ferromagnetischen Elemente 5 nach innen (in Richtung zueinander) möglich ist. Ferner weisen die ferromagnetischen Elemente 5 Schlitze 5 1 auf. Die Schlitze 51 verlaufen im Wesentlichen parallel zur Verbindungsachse 7 und zueinander. Die Schlitze 51 begrenzen zusammen mit den Seitenrändern der ferromagnetischen Element 5 einzelne Bereiche der ferromagnetischen Elemente 5, die bei geeigneter Kraftwirkung unabhängig voneinander bewegbar sind.

Die ferromagnetischen Elemente 5 sind mittels der Federteile 9 bewegbar miteinander verbunden. Benachbart zu den ferromagnetischen Elementen 5 sind Bypassleiter 6 angeordnet. Jeder Bypassleiter 6 ist fest mit einem der ferromagnetischen Elemente 5 verbunden. Befindet sich die Bypassvorrichtung nicht in Aktivstellung, so ist eine Bewegung eines jeden ferromagnetischen Elements 5 einerseits durch die beiden Halteplatten 10 und anderseits durch die Rückstellkraft der Federteile 9 eingeschränkt. Überschreitet der Strom durch die Widerstandselemente 3 einen vordefinierten Ansprechwert. so werden die ferromagnetischen Elemente 5 durch gegenseitige Einwirkung der elektromagnetischen Kräfte des oberen und des unteren Elements 5 und zusätzlich durch die elektromagnetische Kraft, die zwischen den Widerstandselementen 3 und den ferromagnetischen Elementen 5 gegen die Rückstellkraft der Federteile 9 wirkt, in Richtung zueinander bewegt. Gleichzeitig werden die mit den ferromagnetischen Elementen 5 fest verbundenen Bypassleiter 6 in gleiche Richtung bewegt. Die Aktivstellung der Bypassvorrichtung wird erreicht, wenn zwischen den Bypassleitern 6 und den Anschlussplatten 2 elektrischer Kontakt hergestellt ist. Nehmen in Folge der elektrischen Kontaktierung die Bypassleiter 6 am Stromfluss teil, so wirkt zwischen ihnen und den Widerstandselementen 3 eine elektromagnetische Anziehungskraft, die durch die Wechselwirkung der zugehörigen Magnetfelder entsteht. Dadurch werden die Bypassleiter 6 zusätzlich gegen die Anschlussplatten 2 gedrückt. Dies hat den Vorteil, dass Kontaktwiderstand an den entsprechenden Kontaktstellen vermindert wird und eventueller schwach leitender Belag an der Oberfläche der Bypassleiter 6 bzw. der Anschlussplatten 2 überwunden werden kann. Ein kleinerer Kontaktwiderstand hat wiederum einen höheren Stromfluss im Bypassleiter 6 zur Folge, wodurch die elektromagnetische Anzichungskraft weiter steigt. Die Bypassleiter 6 weisen auf der den Anschlussplatten 2 zugewandten Seite Einbuchtungen 61 auf, so dass der Kontakt zwischen den Bypassleitern 6 und den Anschlussplatten 2 nicht über die gesamte betreffende Seitenfläche erfolgt, sondern im Wesentlichen über vier Stützflächen. Auf diese Weise kann vermieden werden, dass eventuelle Oberflächenunregelmäßigkeiten im Bereich der Oberflächen der Bypassleiter 6 und/oder der Anschlussplatten 2 zu einer zusätzlichen Erhöhung der Kontaktwiderstände führen. Zudem wirkt die gesamte Kontaktkraft auf kleinere Bereiche der Bypassleiter 6 und der Anschlussplatten 2 und ergibt dadurch eine höhere Flächenpressung.

Sinkt der Strom durch die Widerstandselemente 3 und die Bypassleiter 6 unter den Ansprechwert, so überwiegt die Rückstellkraft der Federteile 9 die elektromagnetische Anziehungskraft und die Bypassvorrichtung kehrt in ihre Ausgangsstellung zurück, in der kein elektrischer Kontakt zwischen den Bypassleitern 6 und den Anschlussplatten 2 besteht.

### Bezugszeichentabelle

- 1: Messwiderstand
- 2: Anschlussplatte
- 21: Stromanschlussvorrichtung
- 3: Widerstandselement
- 4: elektronische Einheit
- 41: Sensoranschluss
- 5: ferromagnetisches Element
- 51: Schlitz
- 6: Bypassleiter
- 61: Einbuchtung
- 7: Verbindungsachse
- 8: Isolierung
- 9: Federteil
- 10: Halteplatte
- 101: Grundfläche der Halteplatte
- 102: Seitenfläche der Halteplatte

## Patentansprüche

1. Messwiderstand zum Messen eines elektrischen Stromes umfassend zwei Stromanschlussvorrichtungen (21).
wenigstens ein zwischen den Stromanschlussvorrichtungen (21) angeordnetes und mit ihnen leitend verbundenes Widerstandselement (3), und eine zwischen den Stromanschlussvorrichtungen (21) angeordnete und mit ihnen leitend verbundene elektronische Einheit (4) zur Erfassung und Verarbeitung eines Messsignals,
**dadurch gekennzeichnet, dass**
eine Bypassvorrichtung zur Überbrückung des Widerstandselements (3) vorgesehen ist, wobei eine durch den Strom verursachte Kraft die Bypassvorrichtung in eine Aktivstellung bewegt oder in der Aktivstellung hält, wenn der Strom zwischen den Stromanschlussvorrichtungen (21) über einem definierten Ansprechwert liegt,
und dass die Bypassvorrichtung wenigstens einen Bypassleiter (6) umfasst. durch den ein Anteil des Stromes zwischen den Stromanschlussvorrichtungen (21) fließt, wenn die Bypassvorrichtung sich in der Aktivstellung befindet.

2. Messwiderstand nach Anspruch 1, **dadurch gekennzeichnet. dass** die elektronische Einheit (4) im Wesentlichen im Bereich einer Verbindungsachse (7) angeordnet ist. wobei die Verbindungsachse (7) die Stromanschlussvorrichtungen (21) verbindet.

3. Messwiderstand nach Anspruch 1 oder 2, **dadurch gekennzeichnet, dass** mindestens drei zueinander beabstandete und im Wesentlichen parallel verlaufende Widerstandselemente (3) vorgesehen sind, und dass die zwei Stromanschlussvorrichtungen (2 1) und die Widerstandselemente (3). welche sich zwischen den Stromanschlussvorrichtungen (21) erstrecken, einen Raumausschnitt begrenzen, in dem sich die elektronische Einheit (4) befindet.

4. Messwiderstand nach einem der Ansprüche 1 bis 3, **dadurch gekennzeichnet, dass** das von der elektronischen Einheit (4) erfasste Messsignal über eine Koaxialleitung, über einen Lichtsender, über eine Lichtwellenleitung oder per Funk zur Weiterverarbeitung nach außen herausgeführt wird.

5. Messwiderstand nach Anspruch 1 bis 4, **dadurch gekennzeichnet, dass** die Bypassvorrichtung wenigstens ein bewegbares ferromagnetisches Element (5) umfasst,

6. Messwiderstand nach Anspruch 5, **dadurch gekennzeichnet, dass** das ferromagnetische Element (5) als flächiges Segment ausgebildet ist. das sich seiner Länge nach von der einen bis zu der anderen Stromanschlussvorrichtung (21) erstreckt und das zwischen den Stromanschlussvorrichtungen (21) angeordnete Widerstandselement (3) zumindest teilweise umschirmt.

7. Messwiderstand nach Anspruch 6, **dadurch gekennzeichnet, dass** das ferromagnetische Element (5) mindestens einen Schlitz (51) aufweist, der sich in einer Hauptstromrichtung erstreckt.

8. Messwiderstand nach einem der Ansprüche 5 bis 7, **dadurch gekennzeichnet_{,} dass** mindestens ein Federteil (9) zu einer bewegbaren Lagerung des ferromagnetischen Elements (5) vorgesehen ist.

9. Messwiderstand nach einem der Ansprüche 5 bis 8, **dadurch gekennzeichnet, dass** der Messwiderstand (1) eine Isolierung (8) umfasst, wobei das ferromagnetische Element (5) an der Isolierung (8) bewegbar gelagert ist.

10. Messwiderstand nach Anspruch 8, **dadurch gekennzeichnet, dass** der Messwiderstand (1) zwei Isolierungen (8) umfasst, die benachbart zu den Stromanschlussvorrichtungen (21) angeordnet sind, wobei das ferromagnetische Element (5) an wenigstens einer der Isolierungen (8) jeweils mittels mindestens eines Federteils (9) bewegbar gelagert ist.

11. Messwiderstand nach Anspruch 8, **dadurch gekennzeichnet, dass** der Messwiderstand (1) zwei ferromagnetische Elemente (5) umfasst, die miteinander mittels wenigstens eines der Federteile (9) bewegbar verbunden sind.

12. Messwiderstand nach Anspruch 9 oder 10, **dadurch gekennzeichnet, dass** die Isolierungen (8) in Form von im Wesentlichen kreisförmigen Scheiben ausgebildet sind, und dass die Stromanschlussvorrichtungen (21) jeweils eine im Wesentlichen kreisförmige Anschlussplatte (2) umfassen.

13. Messwiderstand nach einem der Ansprüche 1 bis 12, **dadurch gekennzeichnet, dass** die Stromanschlussvorrichtungen (21) jeweils eine im Wesentlichen rechteckige Anschlussplatte (2) umfassen.

14. Messwiderstand nach einem der Ansprüche 8 bis 11, **dadurch gekennzeichnet, dass** der wenigstens eine Bypassleiter (6) derart angeordnet ist, dass durch eine Belastung des Federteils (9) elektrisch leitende Verbindung zwischen den Stromanschlussvorrichtungen (21) und dem Bypassleiter (6) bergestellt werden kann.

15. Messwiderstand nach der Ansprüche 8 bis 11, **dadurch gekennzeichnet, dass** der Bypassleiter (6) zweiteilig aus einem ersten und einem zweiten Bypassleiterteil ausgebildet ist, wobei jeder Bypassleiterteil einseitig leitend mit einer der Stromanschlussvorrichtungen (21) verbunden ist, und dass der Bypassleiter (6) derart angeordnet ist, dass durch eine Belastung des Federteils (9) elektrisch leitende Verbindung zwischen den beiden Bypassleiterteilen hergestellt werden kann.
